# EUROPÄISCHE PATENTSCHRIFT

(11) **EP 0 912 080 B1**
(45) Veröffentlichungstag und Bekanntmachung des Hinweises auf die Patenterteilung: **26.01.2005**
(21) Anmeldenummer: 98117693.6
(22) Anmeldetag: 18.09.1998
(51) Int. Cl.: H05K 5/00, H01H 9/02, H01H 71/02

(54) **Elektrisches Gerät**
Electrical device
Appareil électrique

(30) Priorität: 22.10.1997 DE 19746591
(43) Veröffentlichungstag der Anmeldung: 28.04.1999
(73) Patentinhaber: ABB PATENT GmbH, 68526 Ladenburg (DE)
(72) Erfinder: Schmidt, Karten, Dipl.-Ing., 42477 Radevormwald (DE)
(74) Vertreter: Miller, Toivo

(56) Entgegenhaltungen:
- EP-A- 0 622 821
- DE-A- 2 128 057
- DE-A- 3 411 597
- FR-A- 2 718 282
- GB-A- 2 046 021

## Beschreibung

Die Erfindung betrifft ein elektrisches Gerät, insbesondere Reiheneinbaugerät, mit einem Gehäuse, das aus ersten und zweiten Teilgehäusen zusammengesetzt ist, wobei das erste Teilgehäuse eine bedienseitige Gehäusekappe und das zweite Teilgehäuse einen Gehäusesockel bildet und die Schnittebene der Teilgehäuse entlang der Gehäuselängsachse horizontal in Querrichtung verläuft, welche Teilgehäuse an gegenüberliegenden Seiten von Rastnasen und hierzu kompatiblen Rastöffnungen gebildete Raststellen aufweisen, mittels derer die Teilgehäuse miteinander verrastet sind, sowie formschlüssig wirksame Zentrierhilfen zur Ausrichtung der zusammenzusetzenden Teilgehäuse.

Es ist allgemein bekannt, dass Gehäuse für Elektrogeräte, das heißt zur Aufnahme elektrischer Einrichtungen, mittels einfacher Rastverbindung zusammengehalten werden. Aus der FR-A-2 718 282 ist ein Gehäuse für elektrische Geräte bekannt, welches aus einem Sockel und einem Deckel zusammengesetzt ist, wobei zur Verbindung dieser beiden Gehäuseteile der Deckel mit federnden Armen versehen ist, die endseitig über Rastnasen in korrespondierende Rastöffnungen des Sockels eingreifen. Aus der DE-A-2 128 057 ist ein Gehäuse für Schalter oder dergleichen bekannt, wobei zwei Gehäusehälften mit abgesetzten Randsegmenten vorgesehen sind, welche sich im geschlossenen Zustand des Gehäuses wechselseitig umgreifen.

Für diverse elektrische Geräte, insbesondere für Reiheneinbaugeräte, bestehen darüber hinaus Anforderungen an die Zuverlässigkeit derartiger Gehäuseverbindungen, die darauf abzielen, das zufällige Öffnen oder das unsachgemäße Öffnen durch Unberechtigte zu verhindern. Grundsätzlich soll das Öffnen nur mittels Werkzeug, gegebenenfalls mit einhergehender Beschädigung oder Zerstörung des betreffenden Gehäuses möglich sein. Hierdurch ist eine weitere Verwendung nicht mehr möglich.

In Verfolgung dieses Zieles wurden Rastverbindungen an zusammenzusetzenden Gehäuseteilen entwickelt, bei denen die sonst üblicherweise einzeln hervorragenden Rastnasen an einer zurückgesetzten Führungswand angeformt sind, wodurch die Steifigkeit der Anordnung erhöht wird und ein Nachgeben bei mechanischer Beaufschlagung, zum Beispiel durch Zusammendrückender gegenüberliegenden Gehäusewände, weitestgehend verhindert wird. Allerdings kann dennoch bei örtlicher Kraftaufbringung die betreffende Rastnase aus der zugeordneten Rastöffnung gedrückt und so die Verbindung beider Gehäuseteile gelöst werden.

Um dies zu unterbinden, wurden Lösungen vorgeschlagen, bei denen die Rastöff. nungen mit im geringen Abstand hierzu angebrachten Rippen hinterlegt werden, so dass eine Öffnung des verrasteten Gehäuses tatsächlich ohne Werkzeug nicht möglich ist. Allerdings hat diese Lösung den Nachteil, dass die zusätzlichen Rippen in den Innenraum hineinragen und so den zur Verfügung stehenden, das heißt den zur Unterbringung elektrischer und/oder elektronischer Bauteile erforderlichen, Einbauraum nicht unerheblich einschränken.

Ausgehend von diesem Stand der Technik ist es Aufgabe der Erfindung, ein elektrisches Gerät der eingangs genannten Art zu schaffen, welches ohne Beeinträchtigung des zur Aufnahme von elektrischen und/oder elektronischen Teilen verfügbaren Einbauraums eine sichere Verrastung gewährleistet, die nur mittels Werkzeug lösbar ist.

Diese Aufgabe wird erfindungsgemäß gelöst durch die kennzeichnenden Merkmale der Ansprüche 1 und 11. Weitere vorteilhafte Ausgestaltungen und Weiterbildungen der Erfindung sind in den Unteransprüchen gekennzeichnet.

Entsprechend der Erfindung ist daher vorgesehen, dass die an beiden Teilgehäusen jeweils paarweise vorgesehen Raststellen gegeneinander gerichtet sind und sich so beim Versuch unsachgemäßer Öffnung gegenseitig hemmen. In dem Maße nämlich, wie eine Rastnase eingedrückt wird, um so die Verrastung mit der zugeordneten Rastöffnung zu lösen, wird die benachbarte Rastöffnung gegen die zugeordnete Rastnase beaufschlagt, wodurch das Öffnen mißlingt. Es sind die am ersten Teilgehäuse vorgesehenen Rastnasen an einem gegenüber der Außenwandung des ersten Teilgehäuses zurückgesetzten streifenartigen Wandbereich und die Rastöffnungen beiderseits des zurückgesetzten Wandbereiches angeordnet. Ebenso sind die am zweiten Teilgehäuse befindlichen Raststellen an streifenartigen Wandteilen angeordnet, die mit der Außenwand bündig sind und daran angeformt sind, wobei diese zum zweiten Teilgehäuse gehörigen Wandteile beim Zusammenfügen in das erste Teilgehäuse beziehungsweise in den vom zurückgesetzten Wandbereich gebildeten Freiraum eingreifen. Hierdurch erhält das Gehäuse eine erhöhte Biegesteifigkeit, die ein unsachgemäßes Öffnen des Gehäuses verhindert.

In vorteilhafter Ausgestaltung der Erfindung sind jeweils zwei Raststellen unmittelbar benachbart angeordnet, wodurch sich der zuvor erwähnte gegenseitige Hemmeffekt erhöht. Hierbei sind Abstände zwischen 8 mm und 25 mm, vorzugsweise 15 mm, abhängig von der Gehäusegröße sowie von der Wandsteifigkeit des Gehäuses, besonders vorteilhaft.

In vorteilhafter Weiterbildung der Erfindung sind die Rastnasen und zugeordneten Rastöffnungen jeweils an den Längsseiten der Teilgehäuse angeordnet, wobei bevorzugterweise an jeder Längsseite des Gehäuses vier von Rastnasen und zugeordneten Rastöffnungen gebildete Raststellen vorgesehen sind.

Dementsprechend ist es vorteilhaft, dass in weiterer Ausgestaltung der Erfindung jeweils zwei Rastnasen am ersten Teilgehäuse und zwei Rastnasen am zweiten Teilgehäuse angeordnet sind, denen am jeweils anderen Teilgehäuse befindliche Rastöffnungen zugeordnet sind.

Eine weitere günstige Ausgestaltung der Erfindung, welche die Einbeulsteifigkeit unterstützt ist dadurch gekennzeichnet, dass der streifenartige Außenwandbereich am ersten Teilgehäuse um die Wanddicke nach innen zurückgesetzt ist und dass der streifenartige Außenwandbereich mittels eines rechtwinklig angeformten Verbindungssteges mit der unverändert belassenen Außenwand verbunden ist.

Im Hinblick auf gute und sichere Handhabung wie auch wegen der angestrebten sicheren Verrastung weisen gemäß einer bevorzugten Weiterbildung der Erfindung die an die Außenwand des zweiten Teilgehäuses angeformten streifenartigen Wandteile jeweils am Orte des Versatzes der Außenwand des ersten Teilgehäuses einen Schlitz auf, in welchen der Verbindungssteg des ersten Teilgehäuses beim Zusammenfügen eingreift. Hierdurch wird die Steifigkeit des geteilten Gehäuses weiter verstärkt und die zuvor erläuterte Hemmwirkung gegen manuelles Öffnen unterstützt.

Vorteilhafterweise greift in weiterer Verbesserung ein an die Außenwand des zweiten Teilgehäuses angeformter, durch die Schlitze gebildeter streifenartiger Wandteil in den nach innen versetzten streifenartigen Außenwandbereich des ersten Teilgehäuses ein und füllt diesen bündig aus.

Gemäß einer bevorzugten Ausgestaltung der Erfindung ist hierbei der streifenartige Bereich an den Längsseiten symmetrisch angeordnet.

Eine weitere Verbesserung der Erfindung, welche die sachgemäße Öffnung des Gehäuses des elektrischen Geräts, das heißt mittels Werkzeug, erleichtert, sieht vor dass jede der im zweiten Teilgehäuse angeordneten Raststellen mit einer zu den Schmalseiten des elektrischen Gerätes parallelen außen eingeformten Nut versehen ist. Diese Nuten dienen jeweils zum Ansetzen eines Öffnungswerkzeuges.

Hierbei erweist es sich als vorteilhaft, dass die Breite der außen eingeformten Nut der Breite der Raststelle, das heißt der Breite einer Rastnase beziehungsweise der zugeordneten Rastöffnung, entspricht.

Gemäß einer alternativen Lösung der zugrundeliegenden Aufgabe kann auch vorgesehen sein, dass die an den Längsseiten der beiden Teilgehäuse vorgesehenen Raststellen jeweils beiderseits eines streifenartigen Wandbereiches angeordnet sind, der am ersten Gehäuse parallel zu Außenwand zurückgesetzt ist und so in der Außenwand eine Einformung bildet, in welche jeweils ein kompatibler, am zweiten Gehäuseteil in Verlängerung der Außenwand angeformter streifenartiger Lappen eingreift und hierdurch die Biegesteifigkeit der Seitenwände erhöht.

Hierbei erweist es sich als günstig, wenn die Rastöffnungen beiderseits des zurückgesetzten Wandbereiches am ersten Teilgehäuse angeordnet sind, wobei die Rastnasen am zweiten Teilgehäuse vorgesehen sind und an einer vom streifenartigen Wandbereich jeweils durch einen Schlitz abgetrennten Verlängerung der Außenwand angeordnet sind.

Wie auch bereits bei der ersten Alternative erläutert, ist der streifenartige Außenwandbereich am ersten Teilgehäuse um die Wanddicke nach innen zurückgesetzt und vorteilhafterweise mittels eines rechtwinklig angeformten Verbindungssteges mit der unverändert belassenen Außenwand verbunden, wobei der Verbindungssteg in den jeweils zugeordneten, am zweiten Gehäuseteil vorgesehenen Schlitz eingreift. Auch ist hierbei der streifenartige Bereich an den Längsseiten symmetrisch angeordnet.

Ferner kann auch bei dieser Ausführungsform jede der im zweiten Teilgehäuse angeordneten Raststellen mit einer zu den Schmalseiten des elektrischen Gerätes parallelen außen eingeformten Nut versehen sein, die zum Ansetzen eines Öffnungswerkzeuges dient, wobei die Breite der außen eingeformten Nut der Breite der Raststelle, das heißt der Breite einer Rastnase beziehungsweise der zugeordneten Rastöffnung, entspricht.

Diese und weitere vorteilhafte Ausgestaltungen und Verbesserungen der Erfindung sind Gegenstand der Unteransprüche.

Anhand eines in der schematischen Zeichnung dargestellten Ausführungsbeispiels sollen die Erfindung, vorteilhafte Ausgestaltungen und Verbesserungen sowie besondere Vorteile der Erfindung näher erläutert und beschrieben werden.

Es zeigen:
- Fig. 1: ein komplettes, aus zwei in Fig. 2 und 3 dargestellten Teilgehäusen zusammengesetztes Gehäuse gemäß einer ersten Alternative in Schrägansicht;
- Fig. 2: ein als Gehäusekappe vorgesehenes erstes Gehäuseteil gemäß Fig. 1 in Schrägansicht;
- Fig. 3: ein als Gehäusesockel vorgesehenes zweites Gehäuseteil gemäß Fig. 1 in Schrägansicht;
- Fig. 4: ein als Gehäusekappe vorgesehenes erstes Gehäuseteil gemäß einer zweiten Alternative in Schrägansicht; und
- Fig. 5: ein als Gehäusesockel vorgesehenes zweites Gehäuseteil gemäß einer zweiten Alternative in Schrägansicht.

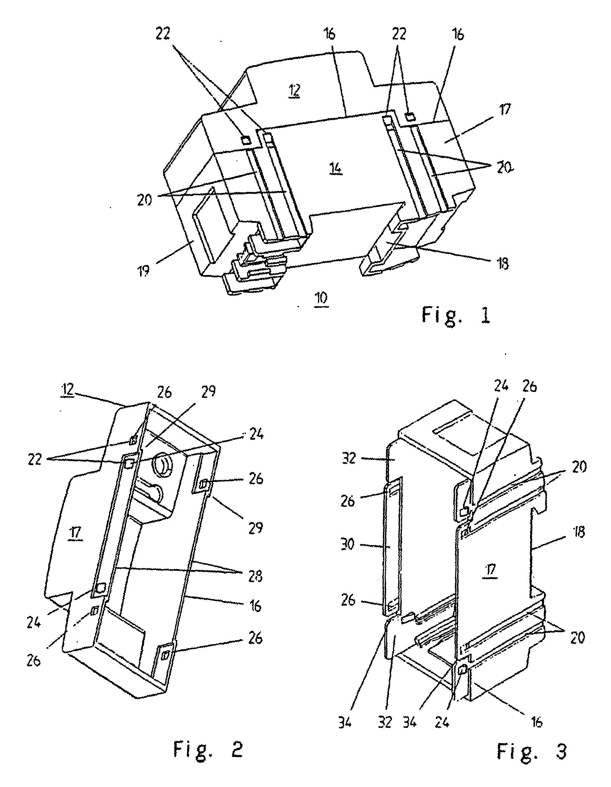

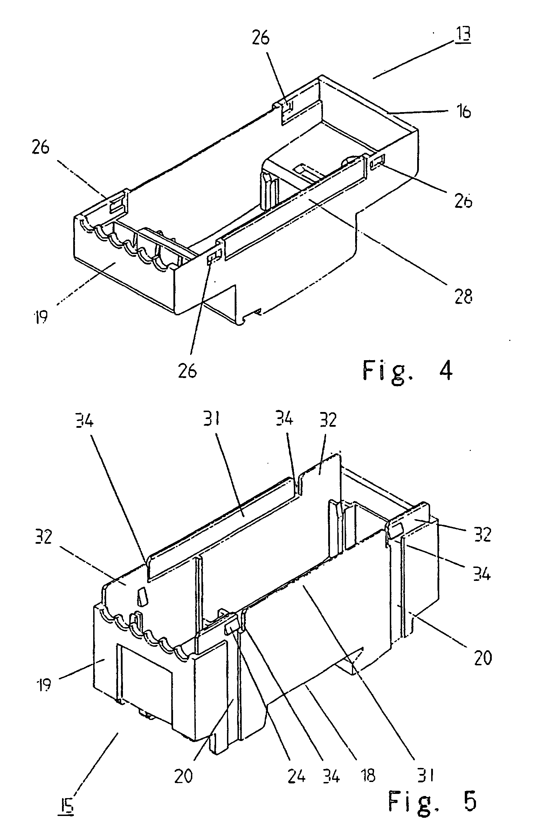

In Fig. 1 ist ein komplettes Gehäuse 10 für ein elektrisches Reiheneinbaugerät gemäß einer ersten Alternative in Schrägansicht dargestellt, das aus zwei in den Fig. 2 und 3 dargestellten Teilgehäusen 12, 14 zusammengesetzt ist, wobei die Trennebene als Trennfuge 16 in Längsrichtung quer zur Hochachse angeordnet ist.

Das oberhalb dargestellte erste Gehäuseteil 12, das als Gehäusekappe dient, ist zur Aufnahme von hier nicht näher dargestellten Bedien- und/oder Anzeigemitteln vorgesehen, während das unterhalb dargestellte zweite Gehäuseteil 14 als Sockel dient und zur Befestigung an einer nicht dargestellten Hutprofilschiene eine entsprechende Einformung 18 aufweist, die mit einer ebenfalls nicht gezeigten federnden Klemmvorrichtung versehen werden kann.

Für die vorliegende Erfindung jedoch sind diese bisher erwähnten Merkmale nicht ausschlaggebend, sondern vielmehr parallel zur Hochachse des Gehäuses 10 in beiden Längsseiten 17 des zweiten eingeformte Rechtecknuten 20, welche jeweils in Raststellen 22 enden, die von Rastnasen 24 an dem einen Gehäuseteil 12, 14 und zugeordneten, hierzu kompatiblen Rastöffnungen 26 am anderen Gehäuseteil 12, 14 gebildet sind.

Wie aus Fig. 2, das ein als Gehäusekappe vorgesehenes erstes Gehäuseteil gemäß Fig. 1 in Schrägansicht zeigt, hervorgeht, sind entlang der Trennebene 16 nahe den Schmalseiten 19 jeweils aus Rastnasen 24 und Rastöffnungen 26 gebildete paarweise Anordnungen von Raststellen 22 angeordnet. Hierbei sind die Rastöffnungen jeweils außen, das heißt den Schmalseiten 19 nächstliegend angeordnet, während die nach außen vorspringenden Rastnasen 24 jeweils an einem bereichsweise um die Wanddicke zurückgesetzten streifenartigen Wandlappen 28 angeformt sind, der sich parallel zur Längsseitenwand 17 erstreckt und mittels eines Verbindungssteges 29 mit der Längsseitenwand 17 verbunden ist.

Dementsprechend sind am zugehörigen, als Gehäusesockel ausgebildeten zweiten Gehäuseteil 14 die Orte der Rastnasen 24 und der Rastöffnungen miteinander vertauscht, so daß sich hier die Rastnasen 24 nächst den Schmalseiten 19 und die Rastöffnungen 26 innenliegend dazwischen befinden.

In Fig. 3 ist das als Gehäusesockel vorgesehene zweite Gehäuseteil 14 gemäß Fig. 1 in Schrägansicht gezeigt, dessen Längsseitenwände 17 jeweils zu den Schmalseiten 19 hin mit insgesamt vier Rechtecknuten 20 versehen sind, die an den von Rastnasen 24 und Rastöffnungen 26 gebildeten Raststellen 22 enden.

Die am Gehäusesockel 14 angeordneten Rastnasen 24 und Rastöffnungen 26 sind an Gehäuselappen 30, 32 angeordnet, die in Verlängerung der Längsseitenwand 17 an diese entlang der Trennebene 16 angeformt sind. Hierbei ist jeweils zwischen paarweise einander zugeordneten Raststellen 22 ein Schlitz 34 vorgesehen, dessen Breite etwa der Wanddicke entspricht und der zur Aufnahme des hierin eingreifenden, am ersten Gehäuseteil 12 vorhandenen Verbindungssteges 29 dient.

In Fig. 4 ist ein als Gehäusekappe vorgesehenes erstes Gehäuseteil 13 gemäß einer zweiten Alternative in Schrägansicht dargestellt, welches sich von dem in Fig. 2 gezeigten ersten Gehäuseteil 12 dadurch unterscheidet, daß an jeder Längsseite 17 nur Rastöffnungen 26 vorgesehen sind, wobei anstelle der gemäß der ersten Ausführungsvariante vorgesehenen, nach außen vorstehenden Rastnasen 24 nur die auch dort bereichsweise zurückgesetzte streifenartige Seitenwand 28 vorgesehen ist, welche so ebenfalls eine außenliegende Einformung bildet, in welche die am Sockelteil 15 gemäß der in Fig. 5 gezeigten zweiten Ausführungsvariante angeformten rastnasenlosen Seitenwandlappen 31 eingreifen und bündig mit der Außenfläche der Seitenwand 17 abschließen.

Auch beim Sockelteil 15 sind Rechtecknuten 20 parallel zur Schmalseite 19 eingeformt, welche an den an den Seitenwandlappen 31 angeformten Rastnasen 24 enden. Die Seitenwandlappen 32 sind ebenfalls durch einen Schlitz 34 von den symmetrisch dazwischen angeordneten Seitenwandlappen 31 getrennt.

Bei der in den Fig. 4 und 5 gezeigten zweiten Alternative wird das Eindrücken der mit den Rastnasen 24 versehenen Seitenwand 17 dadurch verhindert, daß sich der Seitenwandlappen 31 am streifenartigen Wandbereich 28 des Gehäuseoberteils 13 abstützt.

Ferner verhindern die den Raststellen 22 zugeordneten Nuten eine entsprechende Umleitung der zwecks Entriegelung der Raststelle 22 auf die Seitenwand 17 aufgebrachten Eindrückkraft.

## Patentansprüche

1. Elektrisches Gerät, insbesondere Reiheneinbaugerät, mit einem Gehäuse (10), das aus ersten und zweiten Teilgehäusen (12, 14) zusammengesetzt ist, wobei das erste Teilgehäuse (12) eine bedienseitige Gehäusekappe und das zweite Teilgehäuse (14) einen Gehäusesockel bildet und die Schnittebene (16) der Teilgehäuse entlang der Gehäuselängsachse quer zur Hochachse verläuft, welche Teilgehäuse (12, 14) an gegenüberliegenden Seiten (17) von Rastnasen (24) und hierzu kompatiblen Rastöffnungen (26) gebildete Raststellen (22) aufweisen, mittels derer die Teilgehäuse (12, 14) miteinander verrastet sind, sowie formschlüssig wirksame Zentrierhilfen zur Ausrichtung der zusammenzusetzenden Teilgehäuse (12, 14), **dadurch gekennzeichnet, dass** die an beiden Teilgehäusen (12, 14) jeweils paarweise vorgesehen unmittelbar benachbarten Raststellen (22) gegeneinander gerichtet sind und sich so beim Versuch unsachgemäßer Öffnung gegenseitig hemmen, und dass die am ersten Teilgehäuse (12) vorgesehenen Rastnasen (24) an einem gegenüber der Außenwandung des ersten Teilgehäuses (12) zurückgesetzten streifenartigen Wandbereich (28) und die Rastöffnungen (26) beiderseits des zurückgesetzten Wandbereiches (28) angeordnet sind und dass die am zweiten Teilgehäuse (14) befindlichen Raststellen (22) an mit der Seitenwand (17) bündigen, daran angeformten streifenartigen Wandteilen (30, 32) angeordnet sind, die beim Zusammenfügen in das erste Teilgehäuse (12) beziehungsweise in den vom zurückgesetzten Wandbereich (28) gebildeten Freiraum eingreifen.

2. Elektrisches Gerät nach Anspruch 1, **dadurch gekennzeichnet, dass** die Rastnasen (24) und zugeordneten Rastöffnungen (26) jeweils an den Längsseiten (17) der Teilgehäuse (12, 14) angeordnet sind.

3. Elektrisches Gerät nach Anspruch 1 oder 2, **dadurch gekennzeichnet, dass** an jeder Längsseite (17) des Gehäuses (10) vier von Rastnasen (24) und zugeordneten Rastöffnungen (26) gebildete Raststellen (22) vorgesehen sind.

4. Elektrisches Gerät nach Anspruch 3, **dadurch gekennzeichnet, dass** jeweils zwei Rastnasen (24) am ersten Teilgehäuse (12) und zwei Rastnasen (24) am zweiten Teilgehäuse (14) angeordnet sind, denen am jeweils anderen Teilgehäuse (12, 14) befindliche Rastöffnungen (26) zugeordnet sind.

5. Elektrisches Gerät nach einem der vorherigen Ansprüche, **dadurch gekennzeichnet, dass** der streifenartige Außenwandbereich (28) am ersten Teilgehäuse (12) um die Wanddicke nach innen zurückgesetzt ist und dass der streifenartige Außenwandbereich (28) mittels eines rechtwinklig angeformten Verbindungssteges (29) mit der unverändert belassenen Seitenwand (17) verbunden ist.

6. Elektrisches Gerät, nach Anspruch 5, **dadurch gekennzeichnet, dass** die an die Seitenwand (17) des zweiten Teilgehäuses (14) angeformten streifenartigen Wandteile (30) jeweils am Orte des Versatzes der Außenwand des ersten Teilgehäuses (12) einen Schlitz (34) aufweisen, in welchen der Verbindungssteg (29) des ersten Teilgehäuses (12) beim Zusammenfügen eingreift.

7. Elektrisches Gerät, nach Anspruch 5 oder 6, **dadurch gekennzeichnet, dass** in den nach innen versetzten streifenartigen Außenwandbereich (28) des ersten Teilgehäuses (12) ein an die Außenwand des zweiten Teilgehäuses (14) angeformter, durch die Schlitze gebildeter streifenartiger Wandteil (30) eingreift und diesen bündig ausfüllt.

8. Elektrisches Gerät, nach einem der vorherigen Ansprüche, **dadurch gekennzeichnet, dass** der streifenartige Bereich (28) an den Längsseiten (17) symmetrisch angeordnet ist.

9. Elektrisches Gerät, nach einem der vorherigen Ansprüche, **dadurch gekennzeichnet, dass** jede der im zweiten Teilgehäuse (14) angeordneten Raststellen (22) mit einer zu den Schmalseiten (19) des Gehäuses (10) parallelen außen eingeformten Nut (20) versehen ist, die zum Ansetzen eines Öffnungswerkzeuges dient.

10. Elektrisches Gerät, nach Anspruch 9, **dadurch gekennzeichnet, dass** die Breite der außen eingeformten Nut (20) der Breite der Raststelle (22)entspricht.

11. Elektrisches Gerät, insbesondere Reiheneinbaugerät, mit einem Gehäuse, das aus ersten und zweiten Teilgehäusen (13, 15) zusammengesetzt ist, wobei das erste Teilgehäuse (13) eine bedienseitige Gehäusekappe und das zweite Teilgehäuse (15) einen Gehäusesockel bildet und die Schnittebene (16) der Teilgehäuse (13, 15) entlang der Gehäuselängsachse quer zur Hochachse verläuft, welche Teilgehäuse (13, 15) an gegenüberliegenden Seiten von Rastnasen (24) und hierzu kompatiblen Rastöffnungen (26) gebildete Raststellen (22) aufweisen, mittels derer die Teilgehäuse (13, 15) miteinander verrastet sind, sowie formschlüssig wirksame Zentrierhilfen zur Ausrichtung der zusammenzusetzenden Teilgehäuse (13, 15), **dadurch gekennzeichnet, dass** die an den Längsseiten (17) der beiden Teilgehäuse (13, 15) vorgesehenen Raststellen (22) jeweils beiderseits eines streifenartigen Wandbereiches (28) angeordnet sind, der am ersten Gehäuse (13) parallel zur Seitenwand (17) zurückgesetzt ist und so in der Seitenwand (17) eine Einformung bildet, in welche jeweils ein kompatibler, am zweiten Gehäuseteil (15) in Verlängerung der Seitenwand (15) angeformter streifenartiger Lappen (31) eingreift

12. Elektrisches Gerät nach Anspruch 11, **dadurch gekennzeichnet, dass** die Rastöffnungen (26) beiderseits des zurückgesetzten Wandbereiches (28) am ersten Teilgehäuse (13) angeordnet sind und dass die Rastnasen (24) am zweiten Teilgehäuse (15) vorgesehen sind an einer vom streifenartigen Lappen (31) jeweils durch einen Schlitz abgetrennten Verlängerung (32) der Seitenwand (17) angeordnet sind.

13. Elektrisches Gerät nach einem der Ansprüche 11 oder 12, **dadurch gekennzeichnet, dass** der streifenartige Außenwandbereich (28) am ersten Teilgehäuse (13) um die Wanddicke nach innen zurückgesetzt ist.

14. Elektrisches Gerät, nach einem der Ansprüche 11 bis 13, **dadurch gekennzeichnet, dass** der streifenartige Außenwandbereich (28) mittels eines rechtwinklig angeformten Verbindungssteges (29) mit der unverändert belassenen Seitenwand (17) verbunden ist.

15. Elektrisches Gerät nach Anspruch 14, **dadurch gekennzeichnet, dass** jeder Verbindungssteg (29) in den jeweils zugeordneten, am zweiten Gehäuseteil (15) vorgesehenen Schlitz (34) eingreift.

16. Elektrisches Gerät, nach einem der vorherigen Ansprüche, **dadurch gekennzeichnet**, däss der streifenartige Bereich (28, 31 ) an den Längsseiten symmetrisch angeordnet ist.

17. Elektrisches Gerät nach einem der Ansprüche 11 bis 14, **dadurch gekennzeichnet, dass** jede der im zweiten Teilgehäuse (15) angeordneten Raststellen (22) mit einer zu den Schmalseiten (19) des elektrischen Gerätes parallelen außen eingeformten Nut (20) versehen ist, die zum Ansetzen eines Öffnungswerkzeuges dient.

18. Elektrisches Gerät, nach Anspruch 15, **dadurch gekennzeichnet, dass** die Breite der außen eingeformten Nut (20) der Breite der Raststelle (22) entspricht.

## Claims

1. An electric device, especially a serial mounting device, with a housing (10) which is composed of a first and second partial housing (12, 14), with the first partial housing (12) having a housing cap on the operating side and the second partial housing (14) forming a housing base and the plane of intersection (16) of the partial housings extending along the longitudinal axis of the housing transversally to the vertical axis, which partial housings (12, 14) comprise latching points (22) at opposite sides (17) formed by latching noses (24) and latching apertures (26) which are compatible thereto, by means of which the partial housings (12, 14) are latched with each other, as well as centering aids acting in an interlocking manner for the purpose of alignment of the partial housings (12, 14) to be joined, **characterized in that** the latching points (22) which are each provided in pairs in the two partial housings (12, 14) and are directly adjacent to each other face against each other and thus block each in the case of improper opening, and that the latching noses (24) provided on the first partial housing (12) are arranged on a strip-like wall region (28) set back relative to the outside wall of the first partial housing (12) and the latching apertures (26) are arranged on either side of the setback wall region (28) and that the latching points (22) situated on the second partial housing (14) are arranged on strip-like wall parts (30, 32) which are flush with the side wall (17) and are arranged thereon, and which, when joined, engage in the first partial housing (12) or in the cavity formed by the setback wall region (28).

2. An electric device according to claim 1, **characterized in that** the latching noses (24) and the associated latching apertures (26) are each arranged on the longitudinal sides (17) of the partial housings (12, 14).

3. An electric device according to claim 1 or 2, **characterized in that** four latching points (22) are provided which are formed on each longitudinal side (17) by latching noses (24) and associated latching openings (26).

4. An electric device according to claim 3, **characterized in that** two latching noses (24) each are arranged on the first partial housing (12) and two latching noses (24) on the second partial housing (14) to which latching apertures (26) are associated which are located on the respective other partial housing.

5. An electric device according to one of the preceding claims, **characterized in that** the strip-like outer wall region (28) on the first partial housing (12) is set back inwardly by the wall thickness and that the strip-like outer wall region (28) is joined by means of a rectangular shaped connecting web (29) with the unchanged side wall (17).

6. An electric device according to claim 5, **characterized in that** the strip-like wall parts (30) which are formed on the side wall (17) of the second partial housing (14) each comprise a slot (23) at the location of the offset of the outer wall of the first partial housing (12), in which slot engages the connecting web (29) of the first partial housing (12) during the joining.

7. An electric device according to claim 5 or 6, **characterized in that** in the inwardly offset strip-like outer wall region (28) of the first partial housing (12) there engages a strip-like wall part (30) which is formed on the outer wall of the second partial housing (14) and is formed by slots and fills the same in a flush manner.

8. An electric device according to one of the preceding claims, **characterized in that** the strip-like region (28) on the longitudinal sides (17) is arranged in a symmetrical manner.

9. An electric device according to one of the preceding claims, **characterized in that** each of the latching points (22) arranged in the second partial housing (14) is provided with a groove (20) which is formed from the outside parallel to the narrow sides (19) of the housing (10), which groove is used for applying an opening tool.

10. An electric device according to claim 9, **characterized in that** the width of the externally formed groove (20) corresponds to the width of the latching point (22).

11. An electric device, especially a serial mounting device, with a housing which is composed of a first and second partial housing (13, 15), with the first partial housing (13) having a housing cap on the operating side and the second partial housing (15) forming a housing base and the plane of intersection (16) of the partial housings (13, 15) extending along the longitudinal axis of the housing transversally to the vertical axis, which partial housings (13, 15) comprise latching points (22) at opposite sides formed by latching noses (24) and latching apertures (26) which are compatible thereto, by means of which the partial housings (13, 15) are latched with each other, as well as centering aids acting in an interlocking manner for the purpose of alignment of the partial housings (13, 15) to be joined, **characterized in that** the latching noses (24) provided on the longitudinal sides (17) of the two partial housings (13, 15) are arranged on either side of a strip-like wall region (28) which is set back on the first housing (13) parallel to the side wall (17) and thus forms a recessed shaped part in the side wall (17) in which a compatible strip-like tab (31) engages which is formed on the second housing part (15) in extension of the side wall (15).

12. An electric device according to claim 11, **characterized in that** the latching openings (26) are arranged on either side of the setback wall region (28) on the first partial housing (13) and that the latching noses (24) are arranged on the second partial housing (15) on an extension (32) of the side wall (17) separated from the strip-like tab (31) by a slot each.

13. An electric device according to one of the claims 11 or 12, **characterized in that** the strip-like outer wall region (28) is inwardly set back on the first partial housing (13) by the wall thickness.

14. An electric device according to one of the claims 11 to 13, **characterized in that** the strip-like outer wall region (28) is joined by means of a rectangular shaped connecting web (29) with the unchanged side wall (17).

15. An electric device according to claim 14, **characterized in that** each connecting web (29) engages in the respectively associated slot (34) provided on the second housing part (15).

16. An electric device according to one of the preceding claims, **characterized in that** the strip-like region (28, 31) is arranged in a symmetrical way on the longitudinal sides.

17. An electric device according to one of the claims 11 to 14, **characterized in that** each of the latching points (22) arranged in the second partial housing (15) is provided with a groove (20) which is formed from the outside parallel to the narrow sides (19) of the electric device, which groove is used for applying an opening tool.

18. An electric device according to claim 15, **characterized in that** the width of the externally formed groove (20) corresponds to the width of the latching point (22).

## Revendications

1. Appareil électrique, notamment appareil pour montage en série, avec un boîtier (10) constitué par une première et une deuxième partie de boîtier (12, 14), la première partie de boîtier (12) formant, du côté où on le manipule, un capot de boîtier et la deuxième partie de boîtier (14), un socle de boîtier, le plan de coupe (16) des parties de boîtier s'étendant le long de l'axe longitudinal du boîtier en travers de l'axe vertical, lesquelles parties de boîtier (12, 14) comportant, sur des faces (17) situées en regard, des endroits d'encliquetage (22) formés par des ergots d'encliquetage (24) et par des ouvertures d'encliquetage (26) compatibles au moyen desquels les parties de boîtier (12, 14) sont encliquetées l'une dans l'autre ainsi que des moyens auxiliaires de centrage ayant pour effet d'établir une liaison positive en vue de l'alignement des parties de boîtier (12, 14) à assembler, **caractérisé en ce que** les endroits d'encliquetage (22) immédiatement adjacents prévus deux par deux sur les deux parties de boîtier (12, 14) sont dirigés de manière à se faire face, se bloquant ainsi mutuellement lorsque quelqu'un essaie d'ouvrir le boîtier de manière inappropriée et que les ergots d'encliquetage (24) prévus sur la première partie de boîtier (12) sont disposés sur une région de paroi (28) en forme de bande située en retrait par rapport à la paroi extérieure de la première partie de boîtier (12) et les ouvertures d'encliquetage (26) sont disposées de part et d'autre de la région de paroi (28) située en retrait et que les endroits d'encliquetage (22) se trouvant sur la deuxième partie de boîtier (14) sont disposés sur des parties de paroi (30, 32) en forme de bande affleurant la paroi latérale (17) de laquelle elles sont venues de moulage, lesquelles parties de paroi s'engagent, lors de l'assemblage, dans la première partie de boîtier (12), ou plus précisément dans l'espace libre formé par la région de paroi (28) située en retrait.

2. Appareil électrique selon la revendication 1, **caractérisé en ce que** les ergots d'encliquetage (24) et les ouvertures d'encliquetage (26) associées sont respectivement disposés sur les longs côtés (17) des parties de boîtier (12, 14).

3. Appareil électrique selon la revendication 1 ou 2, **caractérisé en ce que** sont prévus, sur chaque long côté (17) du boîtier (10), quatre endroits d'encliquetage (22) formés par des ergots d'encliquetage (24) et par des ouvertures d'encliquetage (26) associées.

4. Appareil électrique selon la revendication 3, **caractérisé en ce que** deux ergots d'encliquetage (24) sont disposés sur la première partie de boîtier (12) et deux autres ergots d'encliquetage (24), sur la deuxième partie de boîtier (14), des ouvertures d'encliquetage (26) situées sur l'autre partie de boîtier (12, 14) respective leur étant associées.

5. Appareil électrique selon l'une quelconque des revendications précédentes, **caractérisé en ce que** la région (28) de la paroi extérieure en forme de bande sur la première partie de boîtier (12) est en retrait vers l'intérieur d'une distance correspondant à l'épaisseur de la paroi et que la région de la paroi extérieure (28) en forme de bande est reliée à la paroi latérale (17) à laquelle aucune modification n'a été apportée au moyen d'une entretoise de liaison (29) venue de moulage à angle droit.

6. Appareil électrique selon la revendication 5, **caractérisé en ce que** les parties de paroi (30) en forme de bande venues de moulage avec la paroi latérale (17) de la deuxième partie de boîtier (14) comportent chacune, à l'endroit où la paroi extérieure de la première partie de boîtier (12) forme le retrait, une fente (34) dans laquelle vient s'engager l'entretoise de liaison (29) de la première partie de boîtier (12) lors de l'assemblage.

7. Appareil électrique selon la revendication 5 ou 6, **caractérisé en ce qu'**une partie de paroi (30) en forme de bande, venue de moulage avec la paroi extérieure de la deuxième partie de boîtier (14) et formée par les fentes, s'engage dans la région (28) de la paroi extérieure en forme de bande de la première partie de boîtier (12) qui est en retrait vers l'intérieur et remplit celle-ci de manière à affleurer.

8. Appareil électrique selon l'une quelconque des revendications précédentes, **caractérisé en ce. que** la région (28) en forme de bande est disposée symétriquement sur les longs côtés (17).

9. Appareil électrique selon l'une quelconque des revendications précédentes, **caractérisé en ce que** chacun des endroits d'encliquetage (22) disposés dans la deuxième partie de boîtier (14) est muni d'une rainure (20) parallèle aux chants (19) du boîtier (10) et ménagée à l'extérieur de celui-ci, cette rainure servant à y appliquer un outil pour ouvrir le boîtier.

10. Appareil électrique selon la revendication 9, **caractérisé en ce que** la largeur de la rainure (20) ménagée sur la face extérieure correspond à la largeur de l'endroit d'encliquetage (22).

11. Appareil électrique, notamment appareil pour montage en série, avec un boîtier constitué par une première et une deuxième partie de boîtier (13, 15), la première partie de boîtier (13) formant, du côté où on le manipule, un capot de boîtier et la deuxième partie de boîtier (15), un socle de boîtier, le plan de coupe (16) des parties de boîtier s'étendant le long de l'axe longitudinal du boîtier en travers de l'axe vertical, lesquelles parties de boîtier (13, 15) comportant, sur des faces (17) situées en regard, des endroits d'encliquetage (22) formés par des ergots d'encliquetage (24) et par des ouvertures d'encliquetage (26) compatibles au moyen desquels les parties de boîtier (13, 15) sont encliquetées l'une dans l'autre ainsi que des moyens auxiliaires de centrage ayant pour effet d'établir une liaison positive en vue de l'alignement des parties de boîtier (13, 15) à assembler, **caractérisé en ce que** les endroits d'encliquetage (22) prévus sur les longs côtés (17) des deux parties de boîtier (13, 15) sont disposés de part et d'autre d'une région de paroi (28) en forme de bande qui est située en retrait sur la première partie de boîtier (13) et est parallèle à la paroi latérale (17), formant ainsi dans la paroi latérale (17) une moulure dans laquelle vient s'engager une patte (31) compatible en forme de bande qui est venue de moulage avec la deuxième partie de boîtier (15) dans le prolongement de la paroi latérale (17).

12. Appareil électrique selon la revendication 11, **caractérisé en ce que** les ouvertures d'encliquetage (26) sont disposées de part et d'autre de la région de paroi (28) située en retrait dans la première partie de boîtier (13) et que les ergots d'encliquetage (24) sont prévus sur la deuxième partie de boîtier (15) et sont disposés sur un prolongement (32) de la paroi latérale (17) qui est séparé de la patte (31) en forme de bande par une fente.

13. Appareil électrique selon l'une quelconque des revendications 11 ou 12, **caractérisé en ce que** la région de paroi extérieure (28) en forme de bande sur la première partie de boîtier (13) est située en retrait vers l'intérieur d'une distance correspondant à l'épaisseur de la paroi.

14. Appareil électrique selon l'une quelconque des revendications 11 à 13, **caractérisé en ce que** la région de paroi extérieure (28) en forme de bande est reliée à la paroi latérale (17) à laquelle aucune modification n'a été apportée au moyen d'une entretoise de liaison (29) venue de moulage à angle droit.

15. Appareil électrique selon la revendication 14, **caractérisé en ce que** chaque entretoise de liaison (29) s'engage dans la fente (34) qui lui est associée et qui est prévue sur la deuxième partie de boîtier (15).

16. Appareil électrique selon l'une quelconque des revendications précédentes, **caractérisé en ce que** la région en forme de bande (28, 31) est disposée symétriquement sur les longs côtés.

17. Appareil électrique selon l'une quelconque des revendications 11 à 14, **caractérisé en ce que** chacun des endroits d'encliquetage (22) disposés dans la deuxième partie de boîtier (15) est muni d'une rainure (20) parallèle aux chants (19) de l'appareil électrique et ménagée à l'extérieur de celui-ci, cette rainure servant à y appliquer un outil pour ouvrir le boîtier.

18. Appareil électrique selon la revendication 15, **caractérisé en ce que** la largeur de la rainure (20) ménagée sur la face extérieure correspond à la largeur de l'endroit d'encliquetage (22).
